# EUROPÄISCHE PATENTSCHRIFT

(11) **EP 0 462 384 B1**
(45) Veröffentlichungstag und Bekanntmachung des Hinweises auf die Patenterteilung: **30.11.1994**
(21) Anmeldenummer: 91107087.8
(22) Anmeldetag: 02.05.1991
(51) Int. Cl.: F21V 19/00, H01R 33/09, H01R 33/46

(54) **Fassung für eine Kleinglühlampe**
Holder for maniature incandescent lamp
Douille pour une ampoule miniature

(30) Priorität: 19.06.1990 DE 4019495
(43) Veröffentlichungstag der Anmeldung: 27.12.1991
(73) Patentinhaber: Albrecht, Paul, D-96052 Bamberg (DE)
(72) Erfinder: Arnold, Werner, W-8600 Bamberg (DE); Müller, Georg, W-8608 Memmelsdorf-Merkendorf (DE)
(74) Vertreter: Matschkur, Götz, Lindner Patent- und Rechtsanwälte

(56) Entgegenhaltungen:
- DE-A- 3 323 814
- US-A- 3 702 455
- US-A- 4 547 840

## Beschreibung

Die Erfindung betrifft eine Fassung für eine Kleinglühlampe zum lösbaren und verriegelbaren Einsetzen in eine Ausnehmung einer Leiterplatte und Kontaktierung der Lampe durch Anpressen der Anschlußdrähte an die Leiterplatte bei getrennt hergestellter Fassung und Lampe, wobei die Fassung aus zwei koaxial übereinander angeordneten zylindrischen Teilen unterschiedlichen Außendurchmessers besteht und der Teil mit kleinerem Außendurchmesser als Hohlzylinder zur Aufnahme der Lampe und zum Einsetzen in die Ausnehmung der Leiterplatte ausgebildet ist.

Eine solche Fassung ist bereits aus der US-PS 4 193 653 bekannt. Bei dieser Ausführungsform besteht die Fassung aus einem einzigen Teil, durch das die Lampenanschlußdrähte hindurchgeführt sind. Im unteren Teil der Fassung verlaufen sie schleifenartig in einer Führung in einen Flansch. Bei eingesetzter Fassung preßt der Flansch die an seiner Oberseite austretenden Anschlußdrähte an die Unterseite der Leiterplatte.

Dieses Prinzip der Kontaktgabe zwischen Lampenanschlußdrähten und Leiterplatte hat gegenüber Bauformen mit integrierten Kontaktelementen aus Metall oder leitfähigem Kunststoff, welche an die Lampenanschlußdrähte angelötet, angeschweißt, angenietet, angeklemmt, angeklebt, angespritzt oder angepreßt werden, mehrere Vorteile. Die Fassung kann in einem einzigen Arbeitsschritt hergestellt werden, weil sie nur aus einem einzigen Kunststoffteil besteht. Da der Glaskolben beim Einsetzen der Lampe weder durch Temperatur noch durch Druck beansprucht wird, sind die Materialeigenschaften des Glaskolbens ohne Bedeutung und die Fassung ist für alle Lampen entsprechender Bauart geeignet.

Die Herstellung der Fassung nach US-PS 4 193 653 ist unkompliziert. Allerdings bereitet das Einsetzen der Lampe in die Fassung erhebliche Schwierigkeiten. Hierzu muß die Lampe mit parallel ausgerichteten Anschlußdrähten voraus in die Fassung eingebracht werden, damit die Anschlußdrähte durch je eine Öffnung am Fassungsboden treten. Anschließend wird jeder Anschlußdraht mindestens noch zweimal durch hierfür vorgesehene Ausnehmungen in einem sockelseitigen Flansch gefädelt. Besonders ungünstig wirkt sich der Umstand aus, daß die Lampenanschlußdrähte im allgemeinen sehr dünn sind und sich leicht umbiegen, wenn sie nicht berührungsfrei eingeführt werden. Ein Einsetzen der Lampe in die Fassung von Hand ist deshalb auch bei kleinen Stückzahlen unzumutbar, so daß ein getrennter Vertrieb von Lampe und Fassung nicht in Frage kommt, sondern die Lampe mit Fassung als fertige Einheit angeboten werden muß. Außerdem erfordert das Einsetzen der Lampe in die Fassung komplizierte feinmechanische und dadurch teure Arbeitsmaschinen.

Bei einer in der US-Patentschrift 4 547 840 beschriebenen Fassung für eine Kleinglühlampe ist zwar das Problem des Durchfädelns der elektrischen Anschlußdrähte der Kleinglühlampe vermieden, da die Drähte durch einen endseitigen Durchbruch der Wandung der Fassung nach außen gebogen sind. Diese Anordnung eignet sich aber überhaupt nicht für eine direkte Kontaktierung beim Aufsetzen auf eine Leiterplatte, sondern man muß hierbei die Anschlußdrähte in entsprechender Weise zu den Anschlußstellen der Leiterplatte hin biegen und dort anlöten. Gerade diese komplizierten Biegearbeiten für den Anschluß und die Notwendigkeit des Anlötens will man aber bei der Bestückung von Leiterplatten unbedingt vermeiden.

Der Erfindung liegt die Aufgabe zugrunde, eine Fassung der eingangs beschriebenen Art so auszugestalten, daß das Einsetzen der Lampe in die Fassung und besonders die richtige Führung der Lampenanschlußdrähte unproblematisch und mit einfachsten Werkzeugen, nötigenfalls von Hand, möglich ist. Um dieser Zielrichtung gerecht zu werden, sieht die Erfindung bei einer Fassung der eingangs bezeichneten Art vor, daß auch der Teil mit größerem Außendurchmesser als Hohlzylinder ausgebildet ist, und zur Aufnahme und zum Durchtritt der vertikal zur Lampenlängsachse abstehenden Anschlußdrähte der Lampe zwei diametral gegenüberliegende Längsschlitze vorhanden sind, deren Weite etwa dem Durchmesser der Anschlußdrähte entspricht und die sich über die gesamte Höhe des Teils von geringerem Durchmesser und um ein höchstens dem Durchmesser der Anschlußdrähte entsprechendes Maß in den Teil von größerem Durchmesser erstrecken. Diese Ausbildung hat zur Folge, daß die Lampe mit nach außen abgebogenen Anschlußdrähten in die Fassung eingesetzt werden kann. Die Anschlußdrähte werden hierbei in den Schlitzen der Fassung geführt und begrenzen die Einsetzbewegung der Lampe dann, wenn sie auf dem Grund der Längsschlitze zur Anlage gelangen. Hierbei kann durchaus ein Paßsitz der Drähte in den Schlitzen in Kauf genommen werden. Die Einheit aus Fassung und Lampe wird dann mit dem Glaskolben voraus von der Unterseite der Leiterplatte in deren Ausnehmung eingeführt, bis die Leiterplatte auf den Anschlußdrähten zur Anlage gelangt. Hierbei bilden die Anschlußdrähte gewissermaßen einen Anschlag, welcher ein weiteres Eindringen der Fassung in die Leiterplattenöffnung verhindert. Der von der Leiterplatte auf die Anschlußdrähte ausgeübte Anpreßdruck stellt einen zuverlässigen Kontakt zwischen den Drähten und den Kontaktflächen an der Leiterplattenunterseite her. Eine zusätzliche Verformung oder ein weiteres Einfädeln der Enden der Anschlußdrähte wird hierbei entbehrlich.

Es liegt im Rahmen der Erfindung, daß die Fassung aus elastischem Werkstoff besteht und in einer Versetzung von 90° zu den in der Fassung angeordneten Schlitzen an dem Teil von größerem Durchmesser zwei achsparallele, radial bewegliche Federn angeordnet sind, die mit einem an ihrem freien Ende nach außen ragenden Rastkopf die Leiterplatte unter Anpressen auf die in den Schlitzen liegenden Anschlußdrähte übergreifen. Die Rastköpfe sind in einem Abstand zur Schulter des Zylinders von größerem Durchmesser angeordnet, der etwas kleiner ist als die mittlere Leiterplattenstärke.

Es hat sich als besonders vorteilhaft erwiesen, daß an der die Fassung aufnehmenden Ausnehmung der Leiterplatte zwei je einen Schaft der Federn führende radiale Vertiefungen angeordnet sind. Hierdurch wird ein Verdrehen der eingesetzten Fassung gegenüber der Leiterplattenöffnung vermieden und die Lampenanschlußdrähte liegen immer auf derselben Stelle der Leiterplattenunterseite an. Daher können die Kontaktflächen auf einen kleinen Kreissektor am Umfang der Leiterplattenöffnung, um 90°zu deren radialen Vertiefungen versetzt, beschränkt werden.

Es liegt im Rahmen der Erfindung, daß die Federn in radialen Ausnehmungen des Hohlzylinders angeordnet und mit ihrem Fuß an dem Teil von größerem Durchmesser der Fassung angeformt sind. Ausnehmungen im Zylinder von geringerem Durchmesser in Form von Vertiefungen oder Schlitzen im Bereich der Federn erhöhen den freien Federweg der Rastköpfe. Diese können größer ausgebildet werden, wodurch die Fassung auch für Leiterplatten geeignet ist, deren Dicke eine größere Toleranz aufweist. Um den Federweg zu vergrößern, können sich die die Federn aufnehmenden Ausnehmungen bis in den Zylinder von größerem Durchmesser hinein erstrecken. Die Tiefe dieser Ausnehmungen wird von der Forderung nach ausreichender Stabilität der Fassung begrenzt.

Eine alternative Ausführungsform der Erfindung zeichnet sich dadurch aus, daß an dem Außenumfang des Teils der Fassung von geringerem Durchmesser zwei gegenüberliegende, die Leiterplatte übergreifende Klemmköpfe unmittelbar angeformt sind, deren axialer Abstand von der Schulter des Teils von größerem Durchmesser etwa der Dicke der Leiterplatte entspricht und die entsprechende radiale Vertiefungen in der Leiterplatte durchgreifen und dieser gegenüber durch Drehung der Fassung arretierbar sind. Hierdurch wird eine Art Bajonettverschluß gebildet. Besonders vorteilhaft ist es, die Klemmköpfe nicht um 90°versetzt gegenüber den Schlitzen anzuordnen und eine eindeutige Arretierungsdrehrichtung vorzusehen. Der einem Klemmkopf näherliegende Schlitz gibt bezüglich des Klemmkopfs die Arretierungsdrehrichtung an. Um zu vermeiden, daß die Lampenanschlußdrähte bei einem zu großen Verdrehwinkel oder bei Drehen in falscher Richtung in den Bereich der radialen Vertiefungen der Leiterplattenöffnung gelangen und beim Zurückdrehen von deren Kante umgebogen werden, ist am in Arretierungsdrehrichtung hinteren Ende mindestens eines Klemmkopfs ein die Drehbewegung begrenzender Anschlag angebracht.

Schließlich sieht die Erfindung in ihrer weiteren Ausgestaltung vor, daß an den Umfang des Teils der Fassung von größerem Durchmesser sich über dessen axiale Länge erstreckende und mit den Schlitzen in Verbindung stehende Einkerbungen zur Aufnahme der abgebogenen Enden der Anschlußdrähte angeordnet sind. Durch die Führung der Enden der Lampenanschlußdrähte wird die Gefahr des Kurzschlusses mit benachbarten Kontakten erheblich verringert. Bei der Fassung mit Bajonettverschluß kann auf diese Weise ein Verbiegen des Drahtes beim Arretieren vermieden werden. Außerdem besteht die Möglichkeit, den Draht so zu formen, daß er teilweise aus der Sohle des Schlitzes herausragt und so eine die Kontaktierung unterstützende Federkraft erzeugt.

Weitere Vorteilhafte, Merkmale, und Vorteile der Erfindung ergeben sich aus der folgenden Beschreibung einiger bevorzugter Ausführungsformen der Erfindung sowie anhand der Zeichnung. Hierbei zeigen:
- Fig. 1: eine Kleinglühlampe mit abgebogenen Anschlußdrähten, vor dem Einsetzen in die Fassung,
- Fig. 2: die Vorderansicht einer ersten Ausführungsform der Erfindung nach dem Einsetzen in eine Leiterplatte,
- Fig. 3: die Draufsicht auf die Fig. 2, ohne Leiterplatte,
- Fig. 4: die um 90°versetzte Ausführungsform nach Fig. 2,
- Fig. 5: die Unterseite der zugehörigen Leiterplatte samt Kontaktflächen,
- Fig. 6: die Vorderansicht einer zweiten Ausführungsform der Erfindung samt eingesetzter Lampe,
- Fig. 7: die Draufsicht auf die Fig. 6,
- Fig. 8: die um 90° versetzte Ausführungsform nach Fig. 6, in eine Leiterplatte eingesetzt,
- Fig. 9: die Unterseite der zugehörigen Leiterplatte samt Kontaktflächen,
- Fig. 10: die Vorderansicht einer weiteren Ausführungsform der Erfindung,
- Fig. 11: die Draufsicht auf die Fig. 10 und
- Fig. 12: die um 90° versetzte Ausführungsform nach Fig. 10, in eine Leiterplatte eingesetzt.

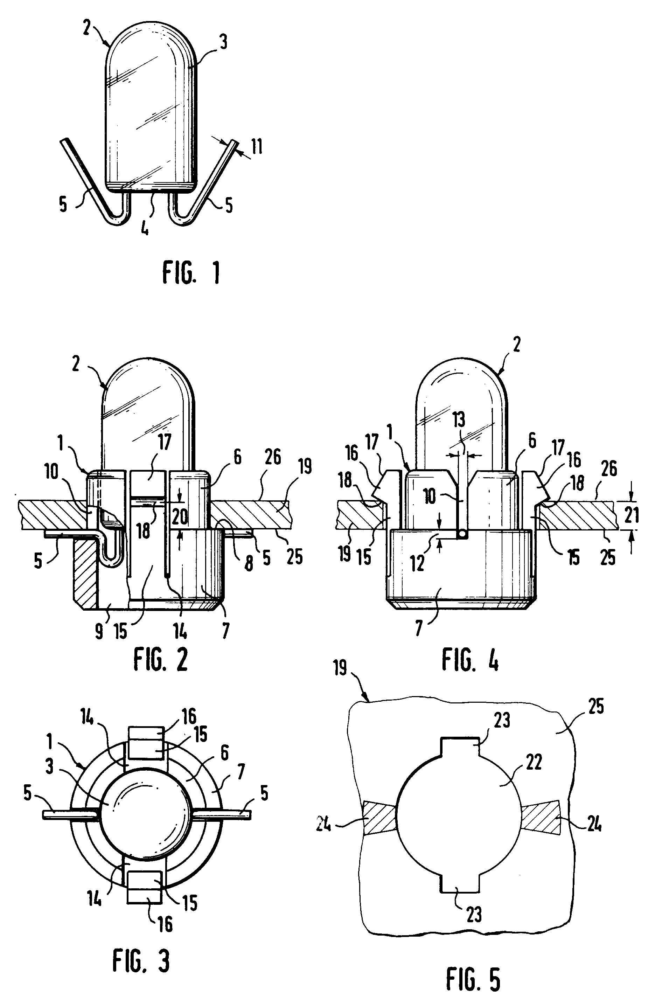

Eine erste Ausführungsform ist in den Fig. 2, 3 und 4 wiedergegeben. Die Fassung 1 dient zur Aufnahme der Kleinglühlampen 2 mit einem zylinderförmigen Glaskolben 3, an dessen Boden 4 zwei Lampenanschlußdrähte 5 austreten. Die Austrittspunkte liegen annähernd diametral zur Längsachse des Glaskolbens 3. Vor dem Einsetzen der Lampe 2 in die Fassung 1 sind die Anschlußdrähte 5 in einem Abstand vom Boden 4 des Glaskolbens 3, der klein im Verhältnis zur Länge der Anschlußdrähte 5 ist, nach oben umzubiegen, so daß sie etwa einen Winkel von 30°zur Längsachse des Glaskolbens 3 bilden, wie es Fig. 1 zeigt. Die Fassung 1 besteht aus elastischem Werkstoff und wird nach außen von den Mantelflächen zweier übereinander angeordneter konzentrischer Zylinder begrenzt. Der obere Teil 6 hat einen geringeren Durchmesser als der untere Teil 7. Dieser ist mit einer Schulter 8 vom oberen Teil 6 abgesetzt. Zur Aufnahme der Lampe 2 dient eine Bohrung 9, die die Fassung 1 auf deren ganzer Länge durchsetzt. Im oberen Teil 6 der Fassung 1 sind zwei diametral gegenüberliegende achsparallele Längsschlitze 10 vorgesehen, welche sich etwa um ein der Dicke 11 der Lampenanschlußdrähte 5 entsprechendes Maß 12 in den unteren Teil 7 der Fassung 1 fortsetzen. Die Weite 13 dieser Schlitze 10 entspricht etwa dem Durchmesser 11 der Lampenanschlußdrähte 5.

Zu den Schlitzen 10 um 90°versetzt sind zwei weitere Schlitze 14 vorhanden, die bei der wiedergegebenen Ausführungsform den schmäleren Zylinderteil 6 auf seiner ganzen Höhe und den breiteren Zylinderteil 7 etwa auf zwei Drittel seiner Höhe durchsetzen. An der Sohle eines jeden Schlitzes 14 ist eine Feder 15 parallel zur Längsachse der Fassung 1 angeformt, welche sich radial außerhalb der Mantelfläche des Zylinders 6 von geringerem Außendurchmesser befindet und innerhalb des Schlitzes 14 aufgrund des geringen radialen Querschnitts des Schafts der Feder 15 radial beweglich ist. Am oberen Ende der Feder 15 befindet sich ein Rastkopf 16, der gegenüber der Feder 15 nach außen vorragt. Der vorspringende Teil 16 wird von einer quer zur Längsachse der Fassung 1 verlaufenden Kante in eine Oberseite 17 und eine Unterseite 18 getrennt. Die Oberseite 17 ist geringfügig gegenüber der Mantelfläche der Feder 15 geneigt. Die Unterseite 18 verläuft in einem spitzen Winkel zur Ebene der Leiterplatte 19 und hat einen mittleren Abstand 20 zur Schulter 8 des breiteren Zylinderteils 7, welcher der Dicke 21 der Leiterplatte 19 entspricht.

Eine zur Aufnahme dieser Ausführungsform der Fassung 1 dienende Leiterplatte 19 zeigt Fig. 5. Sie weist eine im wesentlichen kreisförmige Ausnehmung 22 auf, deren Durchmesser mindestens gleich dem Durchmesser des schmäleren Fassungsteils 6 ist. Zwei diametral am Umfang angeordnete rechteckige Vertiefungen 23 entsprechen in ihrem Querschnitt und in ihrer Lage den Schäften der Federn 15. Die Kontaktflächen 24 bestehen aus Kreissektoren mit einem Öffnungswinkel von etwa 20°, die sich nach außen bis zu einem konzentrischen Kreis mit etwa dem Durchmesser des breiteren Fassungsteils 7 erstrecken.

Zum Einsetzen in die Fassung 1 wird die Lampe 2 mit nach Fig. 1 umgebogenen Anschlußdrähten 5 soweit um ihre Längsachse gedreht, daß je ein Anschlußdraht 5 in einen Schlitz 10 eingreift. Nun wird die Lampe 2 von oben in die Fassung 1 eingeschoben, bis die umgebogenen Lampenanschlußdrähte 5 auf der im breiteren Teil 7 befindlichen Sohle der Schlitze 10 aufliegen. Wegen der Schlitze 10 ist die Fassung 1 im Bereich des schmäleren Teils 6 radial nachgiebig, so daß der Glaskolben 3 mittels Preßpassung gehalten werden kann und jederzeit wieder lösbar ist, z. B. nach einem Durchbrennen der Lampe. Ist die Anordnung starken mechanischen Beanspruchungen ausgesetzt, wie dies in Fahrzeugen der Fall ist, kann der Glaskolben 3 an der Innenseite der Bohrung 9 zusätzlich mit Klebstoff fixiert werden.

Die Kombination aus Fassung 1 und Lampe 2 wird mit dem Glaskolben 3 voraus von der Unterseite 25 der Leiterplatte 19 her eingeführt. Dabei ist die Kombination so um ihre Längsachse zu drehen, daß die Federn 15 mit den seitlichen Aussparungen 23 der Leiterplattenöffnung 22 fluchten. Da die Federköpfe 16 nach außen vorragen, federn sie beim Durchdrücken durch die Aussparungen 23 im Schlitz 14 radial nach innen und schließlich auf der Oberseite 26 der Leiterplatte 19 wieder nach außen.

Die Anordnung der Federn 15 außerhalb der Mantelfläche des Zylinderteils 6 von geringerem Außendurchmesser vermeidet bei in die Leiterplattenöffnung 22 eingesetzter Fassung 1 ein Verdrehen der Fassung 1 gegenüber der Leiterplatte 19.

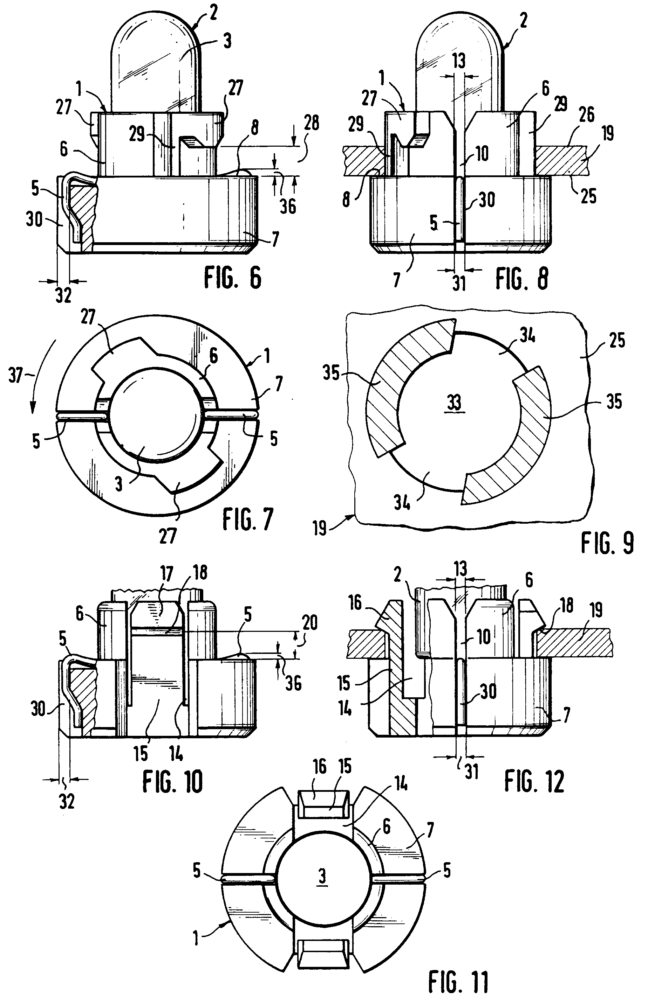

Eine andere Ausgestaltung der erfindungsgemäßen Fassung zeigen Fig. 6, 7 und 8. Im Unterschied zur vorab beschriebenen Fassung treten hier an die Stelle der Federn zwei am Zylinderteil 6 von geringerem Durchmesser in einem von 90° unterschiedlichen Winkel gegenüber den Schlitzen 10 angeordnete, diametral gegenüberliegend Klemmköpfe 27, deren Abstand 28 zur Schulter 8 des Zylinderteils 7 mit größerem Durchmesser der Dicke 21 der Leiterplatte 19 entspricht. An demjenigen Ende der Klemmköpfe 27, welches den größeren Abstand zum nächsten Schlitz 10 aufweist, sind diese als achsenparallele Stege 29 über die ganze Länge des Zylinders 6 von dünnerem Durchmesser ausgebildet. Zwei Einkerbungen 30, deren Weite 31 und Mindesttiefe 32 dem Durchmesser 11 der Lampenanschlußdrähte 5 entspricht, erstrecken sich diametral über die gesamte Höhe des Zylinderteils 7 von größerem Durchmesser und stehen mit den Schlitzen 10 in Verbindung.

Die zugehörige Leiterplatte 19 mit der Öffnung 33 ist Fig. 9 zu entnehmen. Der innere der die Öffnung 33 begrenzenden konzentrischen Kreise hat mindestens denselben Durchmesser wie der schmälere Teil 6 der Fassung 1. Zwei zu den Klemmköpfen 27 kongruente Vertiefungen 34 sind diametral an der Öffnung 33 angeordnet. Der gesamte Umfang zwischen den Vertiefungen 34 dient als Kontaktfläche 35, die sich nach außen in zwei Hälften bis zu einem konzentrischen Kreis von etwa dem Durchmesser des breiteren Fassungsteils 7 erstreckt.

Da die Drähte 5 vor dem Einsetzen der Lampe 2 in die Fassung 1 um mehr als 90° umgebogen sind, ragen sie nach dem Einsetzen schräg aus der Sohle der Schlitze 10 heraus. Zum Schutz der Enden der Lampenanschlußdrähte 5 sind diese zum breiteren Teil 7 der Fassung 1 hin abgewinkelt und in die Einkerbungen 30 eingedrückt. Dabei stehen die Lampenanschlußdrähte 5 im Bereich der Schulter 8 noch um ein Maß 36 aus den Schlitzen 10 über.

Die Fassung 1 wird in eine Leiterplattenöffnung 33 von der Kontaktierungsseite 25 her eingeführt, wobei die Klemmköpfe 27 an den Aussparungen 34 der Leiterplattenöffnung 33 anzusetzen sind. Ist die Fassung 1 so weit eingeschoben, daß die abgebogenen Lampenanschlußdrähte 5 auf die Leiterplattenunterseite 25 angepreßt sind, befinden sich die Klemmköpfe 27 oberhalb der Leiterplatte 19 und die Fassung 1 kann durch Drehen 37 arretiert werden. Die Stege 29 sorgen für eine definierte Befestigungsdrehrichtung 37 und begrenzen gleichzeitig den Drehwinkel.

Bei dieser Ausführungsform übernimmt die Fassung 1 die formschlüssige Verbindung zur Leiterplatte 19. Die Lampenanschlußdrähte 5 erzeugen wegen des Überstands 36 selbst den für die Kontaktierung zur Leiterplatte 19 nötigen Anpreßdruck. Dadurch werden außerdem die Reibungskräfte zwischen der Leiterplatte 19 und den Klemmköpfen 27 erhöht, was einem unbeabsichtigten Ausdrehen der Fassung 1 aus der Leiterplattenöffnung 33 entgegenwirkt.

Die in Fig. 10, 11 und 12 dargestellte Fassung 1 verbindet vorteilhafte Merkmale der Ausführungsformen 1 und 2. Im Unterschied zur Ausführungsform 1 ist der Fassungsteil 7 von größerem Durchmesser verbreitert und mit zwei diametralen Einkerbungen 30 auf seiner gesamten Höhe versehen. Diese Einkerbungen gehen im Bereich der Schulter 8 in die Schlitze 10 über. Ihre Weite 31 und Mindesttiefe 32 entsprechen dem Durchmesser 11 der Lampenanschlußdrähte 5.

Die zugehörige Leiterplatte entspricht grundsätzlich der in Fig. 5 dargestellten. Die Kontaktflächen 24 erstrecken sich wegen des größeren Durchmessers des Teils 7 weiter nach außen.

Das Einsetzen der Lampe 2 in die Fassung 1 erfolgt wie bei der Ausführungsform 2; das Einsetzen der Fassung 1 in eine Leiterplattenöffnung 22 wie bei der Ausführungsform 1. Die aus den Schlitzen 10 um das Maß 36 überstehenden Lampenanschlußdrähte 5 erhöhen den Anpreßdruck und erweitern den Toleranzbereich der Dicke der Leiterplatte 19, in dem eine sichere Kontaktgabe zwischen den Drähten 5 und den Kontaktflächen 24 gewährleistet ist.

Die Ausführungsformen nach den Figuren 2 bis 4 sowie 10 bis 12 haben zusätzlich den Vorteil, daß sie automatisch in die Leiterplatte montiert werden können. Zu diesem Zweck können die Lampen entweder geordnet in einer Palette, aufgereiht auf einem Kunststoffgurt oder in einem Stick ("Vorhangschiene") automatengerecht für einen Greifer eines Bestückungsautomaten angeliefert werden. Darüber hinaus hat die Ausführungsform nach den Fig. 2 - 4 auch noch den Vorzug, daß sie im Schwallbad lötfähig ist, da der Glaskörper durch das Kunststoffteil während des Lötprozesses (es würden bei direktem Kontakt des heißen Lötzinns mit dem Glaskolben Spannungssprünge entstehen) geschützt wird. Die überstehenden Elektroden 5 können somit beim Durchgang einer Schwallbad-Lötanlage automatisch verlötet werden. Bisher konnten Lampen in Anwendungen, die eine geringe Bauhöhe von der Leiterplatten-Oberseite zur Glaskolbenkuppe benötigt haben, nur manuell eingelötet werden.

## Patentansprüche

1. Fassung für eine Kleinglühlampe zum lösbaren und verriegelbaren Einsetzen in eine Ausnehmung einer Leiterplatte und Kontaktierung der Lampe durch Anpressen der Anschlußdrähte an die Leiterplatte bei getrennt hergestellter Fassung und Lampe, wobei die Fassung aus zwei koaxial übereinander angeordneten zylindrischen Teilen unterschiedlichen Außendurchmessers besteht und der Teil mit kleinerem Außendurchmesser als Hohlzylinder zur Aufnahme der Lampe und zum Einsetzen in die Ausnehmung der Leiterplatte ausgebildet ist, dadurch gekennzeichnet, daß auch der Teil mit größerem Außendurchmesser als Hohlzylinder ausgebildet ist, und zur Aufnahme und zum Durchtritt der vertikal zur Lampenlängsachse abstehenden Anschlußdrähte (5) der Lampe (2) zwei diametral gegenüberliegende Längsschlitze (10) vorhanden sind, deren Weite (13) etwa dem Durchmesser (11) der Anschlußdrähte (5) entspricht und die sich über die gesamte Höhe des Teils (6) von geringerem Durchmesser und um ein höchstens dem Durchmesser (11) der Anschlußdrähte (5) entsprechendes Maß (12) in den Teil (7) von größerem Durchmesser erstrecken.

2. Fassung nach Anspruch 1 aus elastischem Werkstoff, dadurch gekennzeichnet, daß in einer Versetzung von 90° zu den Schlitzen (10) an dem Teil (7) von größerem Durchmesser zwei achsparallele, radial bewegliche Federn (15) angeordnet sind, die mit einem an ihrem freien Ende nach außen ragenden Rastkopf (16) die Leiterplatte (19) unter Anpressen auf die in den Schlitzen (10) liegenden Anschlußdrähte (5) übergreifen.

3. Fassung nach Anspruch 2, dadurch gekennzeichnet, daß an der die Fassung (1) aufnehmenden Ausnehmung (22) der Leiterplatte (19) zwei je einen Schaft der Federn (15) führende radiale Vertiefungen (23) angeordnet sind.

4. Fassung nach Anspruch 2 und 3, dadurch gekennzeichnet, daß die Federn (15) in radialen Ausnehmungen (14) des Hohlzylinders (6,7) angeordnet und mit ihrem Fuß an dem Teil von größerem Durchmesser (7) angeformt sind.

5. Fassung nach Anspruch 1, dadurch gekennzeichnet, daß an dem Außenumfang des Teils (6) von geringerem Durchmesser zwei gegenüberliegende, die Leiterplatte (19) übergreifende Klemmköpfe (27) angeformt sind, deren axialer Abstand (28) von der Schulter (8) des Teils (7) von größerem Durchmesser etwa der Dicke (21) der Leiterplatte (19) entspricht und die entsprechende radiale Vertiefungen (34) der Leiterplatte (19) durchgreifen und dieser gegenüber durch Drehung (37) der Fassung (1) arretierbar sind.

6. Fassung nach Anspruch 5, dadurch gekennzeichnet, daß im Bereich des in Arretierungsdrehrichtung (37) hinteren Endes des Klemmkopfs (27) ein die Drehbewegung (37) begrenzender Anschlag (29) angebracht ist.

7. Fassung nach mindestens einem der Ansprüche 1 bis 6, dadurch gekennzeichnet, daß an dem Umfang des Teils (7) von größerem Durchmesser sich über dessen axiale Länge erstreckende und mit den Schlitzen (10) in Verbindung stehende Einkerbungen (30) zur Aufnahme der abgebogenen Enden der Anschlußdrähte (5) angeordnet sind.

## Claims

1. Holder for a miniature fluorescent lamp for detachable and lockable insertion in a recess in a conductor plate and providing contact for the lamp by contact pressure of the connecting leads against the conductor plate, the holder and lamp being manufactured separately, wherein the holder consists of two cylindrical parts disposed coaxially one above the other and having different outer diameters, the part with the smaller outer diameter being formed as a hollow cylinder for receiving the lamp and for insertion in the recess of the conductor plate, characterised in that the part with the larger outer diameter is also formed as a hollow cylinder and in that two diametrically opposed longitudinal slots (10) are provided for receiving and providing a passage for the connecting leads (5) of the lamp (2), which project perpendicular to the lamp longitudinal axis, the width (13) of these slots corresponding approximately to the diameter (11) of the connecting leads (5) and the slots themselves extending along the whole length of the part (6) of smaller diameter and into the part (7) of larger diameter by an amount (12) corresponding at most to the diameter (11) of the connecting leads (5).

2. Holder according to claim 1, composed of resilient material, characterised in that offset at 90° to the slots (10), two axially parallel, radially movable springs (15) are provided in the part (7) of larger diameter, which engage over the conductor plate (19) with a locking head (16) projecting outwards from their free end so as to press against the connecting leads (5) lying in the slots (10).

3. Holder according to claim 2, characterised in that on the recess (22) in the conductor plate (19) for receiving the holder (1), two radial grooves (23) are provided, each guiding a shank of the springs (15).

4. Holder according to claim 2 and 3, characterised in that the springs (15) are disposed in radial recesses (14) in the hollow cylinder (6,7) and their base is integrally formed with the part of larger diameter (7).

5. Holder according to claim 1, characterised in that two opposing clamping heads (27) engaging over the conductor plate (19) are integrally formed on the outer circumference of the part (6) of smaller diameter, the axial distance (28) of these clamping heads from the shoulder (8) of the part (7) of larger diameter approximately corresponding to the thickness (21) of the conductor plate (19), the clamping heads (27) passing through corresponding radial grooves (34) in the conductor plate (19) and being lockable with respect to these grooves by rotation (37) of the holder (1).

6. Holder according to claim 5, characterised in that a stop (29) for limiting rotary motion (37) is mounted at the rear end of the clamping head (27) in the direction of rotation (37) associated with locking.

7. Holder according to at least one of claims 1 to 6, characterised in that notches (30) communicating with the slots (10) extending over the axial length of the part (7) of larger diameter are provided on the circumference of said part (7) in order to receive the bent-back ends of the connecting leads (5).

## Revendications

1. Douille pour ampoule à incandescence miniature susceptible d'être insérée de manière amovible et verrouillable dans un évidement d'une plaquette de conducteurs et de venir en contact avec l'ampoule par application des fils de connexion à la plaque de conducteurs lorsque la douille et l'ampoule sont fabriquées séparément, la douille étant constituée de deux parties cylindriques de différents diamètres extérieurs, agencées coaxialement l'une, au-dessus de l'autre, et la partie de moindre diamètre extérieur est constituée sous la forme d'un cylindre creux, pour recevoir l'ampoule et pour pouvoir s'insérer dans l'évidement de la plaque de conducteurs, caractérisée en ce que la partie de plus grand diamètre extérieur est constituée aussi sous la forme d'un cylindre creux, et qui sont présentes, pour recevoir et faire passer les fils de connexion (5) de l' ampoule (2), qui s' écartent verticalement de l'axe longitudinal de l'ampoule, deux fentes longitudinales (10) diamétralement opposées, dont la largeur (13) correspond à peu prés au diamètre (11) des fils de connexion (5), et qui s'étendent sur la hauteur totale de la partie (6) de moindre diamètre et sur une distance (12) correspondant, au plus, au diamètre (11) des fils de connexion (5) dans la partie (7) de plus grand diamètre.

2. Douille selon la revendication 1 constituée d'un matériau élastique, caractérisée en ce que, en décalage de 90° vis-à-vis des fentes (10), à la partie (7) de plus grand diamètre, on a agencé deux ressorts (15) à axes parrallèles, mobiles radialement, qui s'accrochent, par une tête d'encliquetage (16) faisant saillie vers l'extérieur à leur extrémité libre, sur la plaque à conducteurs (19), par pression sur les fils de connexion (5), qui se trouvent dans les fentes (10).

3. Douille selon la revendication 2, caractérisée en ce que deux renfoncements radiaux (23), guidant chacun une queue des ressorts (15), sont agencés à l'évidement (22) de la plaque de conducteurs (19) recevant la douille (1).

4. Douille selon les revendications 2 et 3, caractérisée en ce que les ressorts (15) sont agencés dans des évidements radiaux (14) du cylindre creux (6,7) et sont conformés avec leur pied à la partie de plus grand diamètre (7).

5. Douille selon la revendication 1, caractérisée en ce qu'à la périphérie extérieure de la partie (6) de moindre diamètre, sont conformées deux têtes de serrage (27) en regard chevauchant la plaque de conducteurs (19), dont la distance axiale (28) vis-à-vis de l'épaulement (8) de la partie (7) de plus grand diamètre correspond à peu prés à l'épaisseur (21) de la plaque de conducteurs (19), qui pénètrent dans des cavités radiales (34) correspondantes de la plaque de conducteurs (19) et sont arrêtées en regard de celle-ci par rotation (37) de la douille (1).

6. Douille selon la revendication 5, caractérisée en ce qu'une butée (29) limitant le mouvement de rotation (37) est agencée dans la zone de l'extrémité arrière de la tête de serrage (27) dans le sens de rotation d'arrêt (37).

7. Douille selon au moins l'une des revendications 1 à 6, caractérisée en ce que des rainures (30), s'étendant à la périphérie de la partie (7) de plus grand diamètre sur sa longueur axiale, et en liaison avec les fentes (10), sont agencées pour recevoir les extrémités recourbées des fils de connexion (5).
